# EUROPEAN PATENT APPLICATION

(11) **EP 2 492 577 A2**
(43) Date of publication of application: **29.08.2012**
(21) Application number: 12155590.8
(22) Date of filing: 15.02.2012
(51) Int. Cl.: F21K 99/00, H01L 25/075

(54) **Light Emitting Device**

(30) Priority: 22.02.2011 JP 2011036467
(71) Applicant: Panasonic Corporation, Osaka 571-8501 (JP)
(72) Inventor: Tanaka, Kenichiro, Neyagawa, Osaka (JP); Urano, Youji, Ikeda, Osaka (JP); Yokotani, Ryoji, Hirakata, Osaka (JP)
(74) Representative: Rüger, Barthelt & Abel

(57) **Abstract**

[Summary]

[Object] To improve an efficiency of light derivation and reduce luminance unevenness in a light emitting device.

[Means for Settlement] Alight emitting device 1 includes a wiring board 2, a plurality of light emitting parts 3 each including an LED 31 installed on the wiring board 2 and a light diffusion part 7 covering the plurality of light emitting parts 3 in common. The wiring board 2 has a high reflective layer 22, an electrically conductive circuit layer 23 and an insulating heat dissipation layer 24 provided in this order from a side of installing the LED 31. Among the lights emitted from the LED 31, the lights diffused by the light diffusion part 7 and returned in the inward direction of the light emitting device 1 are reflected by the high reflective layer 22 and directed outward of the light emitting device 1 again. Thus, the efficiency of the light derivation of the light emitting device 1 can be improved. And since the lights reflected by the high reflective layer 22 can be derived from every position of the light diffusion part 7, the lights derived from the light diffusion part 7 become the lights with the irradiance averaged over the entire light diffusion part 7 while reducing the luminance unevenness.

## Description

### [Field of the Invention]

The present invention relates to a light emitting device having an intention of improving an efficiency of light derivation and reducing luminance unevenness.

### [Background Art]

Conventionally, there has been known a light emitting device using a solid light-emitting element such as an LED (Light Emitting Diode) as a light source (see, e.g., Patent Literature 1). For example, as shown in Fig. 9, such a light emitting device includes a plurality of LEDs 20 emitting blue lights installed on a wiring board 10. These LEDs 20 are collectively sealed with a sealing member 30, and a fluorescent layer 40 is provided on a light derivation surface of the sealing member 30. The fluorescent layer 40 contains yellow fluorescent substances 41 that emit yellow lights excited by the blue lights. The yellow lights generated by the yellow fluorescent substances 41 and the blue lights from the LEDs 20 having not been absorbed by the yellow fluorescent substances 41 are mixed to each other so as to produce white lights that are diffused in various directions by light diffusion substances 51 and thereafter derived from a light diffusion part 50 (light paths thereof being shown by dotted line arrows).

### [Conventional Technique Document]

### [Patent Literature]

[Patent Literature 1] JP2010-123918A

### [Disclosure of the Invention]

### [Problems to be solved by the Invention]

However, in the light emitting device of Patent Literature 1, since the lights emitted by the LEDs 20 are likely diffused by the light diffusion substances 51 so as to be returned in an inward direction of the light emitting device, the efficiency of light derivation of the light emitting device is low. Also, since a light irradiation angle of an LED is generally narrow, even if the light diffusion part 50 is provided, a luminance in the vicinity of the LEDs 20 becomes higher than that of a periphery thereof so that there occurs luminance unevenness.

The present invention has been made to solve the problem mentioned above, and an object thereof is to provide a light emitting device having a high efficiency of light derivation and emitting lights with reduction of luminance unevenness.

### [Means adapted to solve the Problems]

A light emitting device of the present invention includes: a wiring board; and a plurality of light emitting parts each of which includes a solid light-emitting element installed on the wiring board and a first transparent optical sealing part for sealing the solid light-emitting element, wherein the most part of the sealing parts includes fluorescent substances for wavelength-converting lights emitted from the solid light-emitting element so as to derive the wavelength-converted lights while a part of the sealing parts includes no fluorescent substance and transmits the lights without being wavelength-converted. The light emitting device further includes: an activation driver for controlling the light emission of the plurality of light emitting parts; a second transparent optical sealing part for covering the plurality of light emitting parts in common; and a light diffusion part placed on a light derivation surface of the second transparent optical sealing part, wherein the wiring board has a high reflective layer, an electrically conductive circuit layer and an insulating heat dissipation layer provided in this order from a side of installing the solid light-emitting elements.

Preferably, the light diffusion part is rendered to have a linear transmittance of 50% or lower.

Preferably, the light diffusion part is provided with the fluorescent substances on the surface or reverse surface or inside thereof.

Preferably, the light diffusion part is provided with a fluorescent sheet adhered to the surface or reverse surface thereof.

Preferably, the light diffusion part contains light diffusion substances dispersed inside thereof.

Preferably, the plurality of light emitting parts are arranged in an array (line shape) or matrix shape on the wiring board.

Preferably, the second transparent optical sealing part is formed in a plate shape having a larger size than that necessary for covering the plurality of light emitting parts in common.

Preferably, the high reflective layer has its surface composed of a high light reflective member with a light reflectance of 80% or higher.

### [Effect of the Invention]

According to the light emitting device of the present invention, since the high reflective layer is provided on the solid light-emitting element installation surface of the wiring board, the lights diffused in the light diffusion part and returned in the inward direction of the light emitting device among the lights emitted from the solid light-emitting elements are reflected by the high reflective layer and directed outward the light emitting device again. Thus, the efficiency of light derivation of the light emitting device can be improved. Moreover, since the lights reflected by the high reflective layer can be derived from every position of the light diffusion part, the lights derived from the light diffusion part become the lights with its irradiance averaged over the entire parts of the light diffusion part while reducing luminance unevenness.

### [Brief Description of Drawings]

[Fig. 1] Fig. 1 is a plan view of a light emitting device pertaining to a first embodiment of the present invention.
[Fig. 2] Fig. 2 is a section view across an I-I line in Fig. 1.
[Fig. 3] Fig. 3 is a section view of a light emitting device pertaining to a first modified example of the above embodiment.
[Fig. 4] Figs. 4 (a), (b) and (c) are respectively section views of light emitting devices pertaining to a second modified example of the above embodiment.
[Fig. 5] Fig. 5 is a plan view of a light emitting device pertaining to a third modified example of the above embodiment.
[Fig. 6] Fig. 6 is a plan view of a light emitting device pertaining to a second embodiment of the present invention.
[Fig. 7] Fig. 7 is a section view across an I-I line in Fig. 6.
[Fig. 8] Fig. 8 is a section view across an II-II line in Fig. 6.
[Fig. 9] Fig. 9 is a section view of a conventional light emitting device.

### [Best Mode for Carrying Out the Invention]

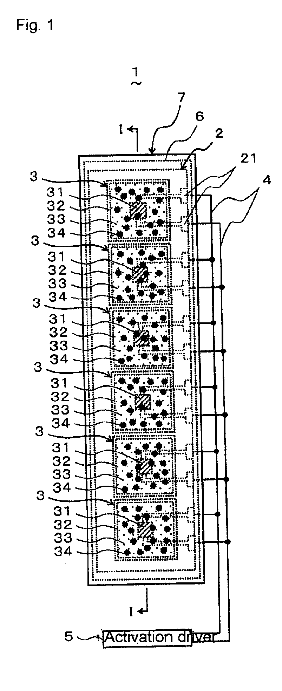

A light emitting device pertaining to a first embodiment of the present invention is described below referring to Figs. 1 to 5. The light emitting device of the present embodiment uses an LED as a solid light-emitting element.

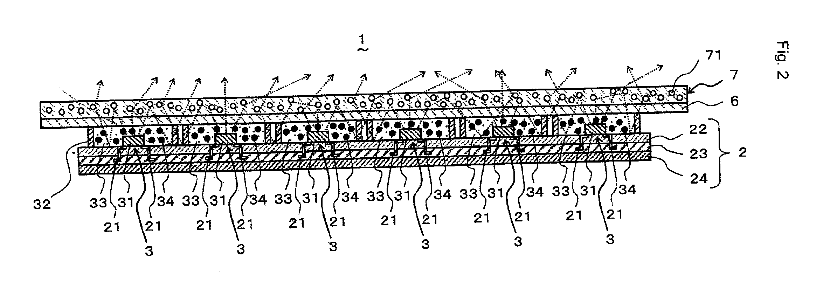

As shown in Figs. 1 and 2, the light emitting device 1 is a linear-shaped light emitting device that includes a long-sized wiring board 2 and a plurality of light emitting parts 3 which are adjacent to each other and installed on the wiring board 2 in an array (linear shape). The wiring board 2 has a three-layer structure that includes a high reflective layer 22, an electrically conductive circuit layer 23 and an insulating heat dissipation layer 24 in this order from a side of installation of the light emitting parts 3 (see Fig. 2). Each of the light emitting parts 3 includes an LED 31 emitting a blue light, a frame member 32 surrounding a periphery of the LED 31 and a first transparent optical sealing part 33 filled in a region surrounded by the frame member 32. In the first transparent optical sealing part 33, there are dispersed yellow fluorescent substances 34 which are excited by the blue lights from the LED 31 and emit yellow lights. Each of the light emitting parts 3 is electrically connected to an activation driver 5 through wiring patterns 21 and distribution lines 4 provided for the respective light emitting parts 3 (see Fig. 1). On the light derivation surface of the light emitting parts 3, there is provided a second transparent optical sealing part 6 for covering the plurality of light emitting parts 3 in common. On the light derivation surface of the second transparent optical sealing part 6, there is provided a light diffusion part 7 which contains light diffusion substances 71.

In the present embodiment, although the wiring board 2 is formed to have a long-sized plate shape of 270mm × 30mm, the size and shape of the wiring board 2 are not limited to the above. The thickness of the wiring board 2 is made to be in a degree such that a deformation such as a deflection does not occur at the time treating the wiring board 2. In addition, although not shown in the drawings, the wiring board 2 is provided with a casing and is attached to a ceiling or a wall etc. through a holding structure provided on the casing.

The high reflective layer 22 of the wiring board 2 includes a conductive material such as aluminum or stainless steel in a degree of 1mm thickness or an electrically insulating material such as alumina ceramics or aluminum nitride, as a base material. The high reflective layer 22 has a flat high reflective member including silver, aluminum or the like material having a light reflectance of 80% or higher provided on the surface thereof. Herein, the wording "flat" means a shape with concave and convex irregularity having a difference in height of at most approximately 75 µm.

The electrically conductive circuit layer 23 of the wiring board 2 includes an epoxy resin, a glass epoxy resin or the like material with high electrical insulating properties and heat conductivity as a base material and includes the wiring patterns 21 embedded in the base material. The wiring pattern 21 includes such as a silver foil and extends from an end portion of the wiring board 2 to a corresponding position beneath the LED 31. The wiring pattern 21 extending to the corresponding position beneath the LED 31 enters the high reflective layer 22 therefrom and is electrically connected to the LED 31 on the surface of the high reflective layer 22. Meanwhile, the wiring pattern 21 derived to the end portion of the wiring board 2 is electrically connected to the distribution lines 4.

The insulating heat dissipation layer 24 of the wiring board 2 includes such as an epoxy resin, a glass epoxy resin or the like material with high electrically insulating properties and heat conductivity.

The LED 31 is formed in a size of approximately 0.3 mm square and includes a nitride material such as indium gallium nitride (InGaN) and the like material. In the present embodiment, although the LED 31 is an LED for emitting a blue light having a peak wavelength of approximately 460nm, it is not limited to this and may be an LED for emitting a light of the other color. In addition, the size and composing material of the LED 31 are not limited to those of the above examples and various changes can be made. Moreover, the kinds of the LEDs 31 may be different every light emitting part 3 or a plurality of LEDs 31 may be included in one light emitting part 3. Further, the LED 31 may be flip-chip mounted or face-up mounted to the wiring pattern 21.

The frame member 32 is formed to be a rectangular shape in top plan view and includes a heat resistant resin material such as, e.g., a transparent silicon resin or an epoxy resin having light transmitting properties and a refractive index of 1.2 to 1.7. In addition, the shape of the frame member 32 is not limit to a rectangular shape and may be, e.g., a hemisphere shape or a half-elliptic shape.

The first transparent optical sealing part 33 includes a heat resistant material having light transmitting properties such as, e.g., a transparent silicon resin or transparent silicon rubber, an acrylic resin, transparent glass or transparent ceramics. The first transparent optical sealing part 33 is adapted to seal the LED 31 and it is preferable to include a material having a refractive index substantially the same as that of the frame member 32.

In the present embodiment, although the fluorescent substances dispersed in the first transparent optical sealing part 33 are yellow fluorescent substances 34, these are not limited to the yellow fluorescent substances 34 and may be those emitting lights excited by the light from the LED 31. Moreover, the fluorescent substances dispersed in the first transparent optical sealing part 33 may be different every light emitting part 3 and may include a plurality of kinds of fluorescent substances. In addition, the first transparent optical sealing part 33 does not necessarily include fluorescent substances and it may transmit the light from the LED 31 as it is.

The activation driver 5 is provided with a switch and a microcomputer etc. and is connected to a commercial power source (not shown). The activation driver 5 is provided with a dimming device (not shown) and controls a supply of electric power obtained from the commercial power source to the light emitting parts 3 so as to control the light emission of the light emitting parts 3. Herein, in the present embodiment, although the activation driver 5 is adapted to collectively control the entire light emitting parts 3, a plurality of activation drivers 5 may be provided so that the activation drivers 5 independently control specified light emitting parts 3, respectively.

The second transparent optical sealing part 6 includes, e.g., a translucent silicon resin, a translucent epoxy resin or translucent glass, and it is formed to be plate-shaped with a size larger than that necessary for covering the light emitting parts 3 in common. The second transparent optical sealing part 6 is adhered to the light derivation surface of the light emitting parts 3 by a light transmitting adhesive having components such as, e.g., a silicon resin or an epoxy resin. Preferably, the second transparent optical sealing part 6 includes a material having a refractive index in the same degree as that of the first transparent optical sealing part 33.

Preferably, the light diffusion part 7 includes a transparent material such as, e.g., a silicon resin, glass or an acrylic resin containing light diffusion substances 71 dispersed inside thereof and it has a linear transmittance of 50% or lower. The light diffusion substance 71 includes, e.g., powdery silicon dioxide or ceramics. The light diffusion part 7 is not necessarily required to contain the light diffusion substances 71 inside thereof but it may be constructed to have light diffusion properties by forming concave and convex irregularities on at least one of the surface and reverse surface thereof by a frost process or the like. The light diffusion part 7 is adhered to a light derivation surface of the second transparent optical sealing part 6 with a light-transmitting adhesive having components of a silicon resin, an epoxy resin or the like.

An action of the light emitting device 1 configured as described above is described below. As shown in Fig. 2, the blue lights (shown by dotted arrow marks) emitted from the LEDs 31 are partly wavelength-converted to yellow lights by the yellow fluorescent substances 34 and the resultant yellow lights are then inputted to the light diffusion part 7. Meanwhile, the other blue lights which are not absorbed by the yellow fluorescent substances 34 are also inputted to the light diffusion part 7 without being wavelength-converted. Thus, the yellow lights and the blue lights are intermixed to be white lights which are diffused to various directions by the light diffusion substances 71 in the light diffusion part 7 and thereafter derived from the light diffusion part 7. At this time, a part of the white lights may be diffused by the light diffusion substances 71 and likely returned in the inward direction of the light emitting device 1. Such so-called return lights are reflected by the high reflective layer 22 almost without attenuation of the light energy thereof so that the resultant lights are directed outward of the light emitting device 1 again. Therefore, the return lights are eventually derived from the light diffusion part 7, which results in that the efficiency of the light derivation of the light emitting device 1 is improved. Moreover, since the white lights reflected by the high reflective layer 22 can be derived from every position of the light diffusion part 7, the lights derived from the light diffusion part 7 become the lights with the irradiance averaged over the entire light diffusion part 7 while reducing the luminance unevenness.

The white lights derived from the light diffusion part 7 can be freely on/off controlled or dimming-controlled by adjusting a power supply to the LEDs 31 using the activation driver 5. In addition, the color tone and luminosity of the white lights derived from the light diffusion part 7 can be also adjusted by changing the kinds and concentration of the fluorescent substances dispersed in the first transparent optical sealing part 33 and by changing a concentration ration in the case where a plurality of fluorescent substances are dispersed.

In the case where the light diffusion part 7 includes glass or an acrylic resin etc. with a relatively high hardness, the light diffusion part 7 can be functioned not only as a light diffusion member but also as an outer shell member for protecting the light emitting device 1 from a damage and the like.

Since the translucent second transparent optical sealing part 6 is formed to have a size larger than that necessary for covering the plurality of light emitting parts 3 in common, the light emitting parts 3 can be masked from a user of the light emitting device 1. Thus, since the light emission of the light emitting part 3 is not directly visible from the user, the circumference of the light emitting device 1 becomes inconspicuous, and therefore the appearance of the light emitting device 1 can be enhanced. Moreover, by forming the second transparent optical sealing part 6 to have a simple shape of flat plate, the production thereof can be facilitated.

Since the refractive index of the first transparent optical sealing part 33, the refractive index of the second transparent optical sealing part 32 and the refractive index of the frame member 32 are made in the same degree, a light reflection loss when the lights emitted from the LEDs 31 pass through an interface of these members can be reduced.

The insulating heat dissipation layer 24 of the wiring board 2 dissipates heat generated in the light emitting device 1 due to the light emission of the LEDs 31 and the like. Thus, an abnormal temperature rise in the light emitting device 1 can be prevented so that a stable operation of the light emitting device 1 can be ensured.

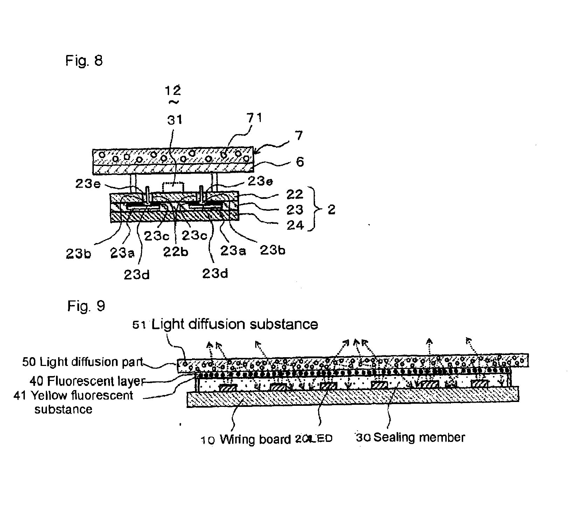

In the light emitting device 1, each of the plurality of LEDs 31 is individually sealed with the first transparent optical sealing part 33 so as to form one independent light emitting part 3. Therefore, even if a malfunction is caused in one of the light emitting parts 3, only the defective light emitting part 3 can be exchanged. Whereas, in the light emitting device of Patent Literature 1 as shown in Fig. 9, since the plurality of LEDs are collectively sealed, when a malfunction occurs in one of the LEDs, it is difficult to change only the defective LED. Therefore, by configuring the light emitting device 1 provided with the plurality of light emitting parts 3 independently from one another as described above, when a malfunction occurs in one of the light emitting parts 3, it becomes possible to deal with the malfunction efficiently at a lower cost.

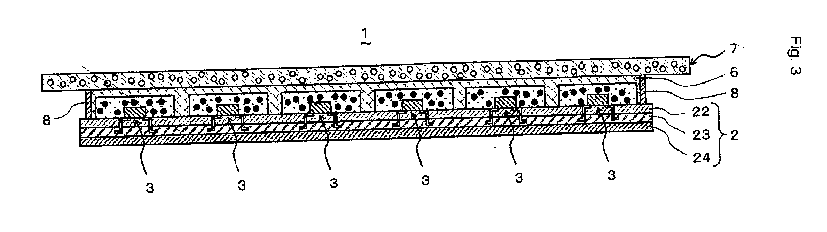

A first modified example of the light emitting device 1 is shown in Fig. 3. As shown in Fig. 3, the light emitting device 1 does not includes the frame member 32 and the light emitting parts 3 are entirely sealed with the second transparent optical sealing part 6. A supporting member 8 collectively surrounding the plurality of light emitting parts 3 is arranged around the light emitting parts 3 in a manner of being attached onto the high reflective layer 22 of the wiring board 2. The supporting member 8 supports the light diffusion part 7 on its surface opposite to a surface contacting the high reflective layer 22.

The supporting member 8 is rectangular shaped in top plan view and includes a light transmitting material such as, e.g., a transparent silicon resin or an epoxy resin. The supporting member 8 preferably includes a material having a refractive index in the same degree as that of the frame member 32. Herein, the shape of the supporting member 8 is not limited to a rectangular shape and it may be, e.g., an ellipse.

According to the first modified example, since the number of the members composing the light emitting device 1 is reduced, the light emitting device 1 can be manufactured more simply.

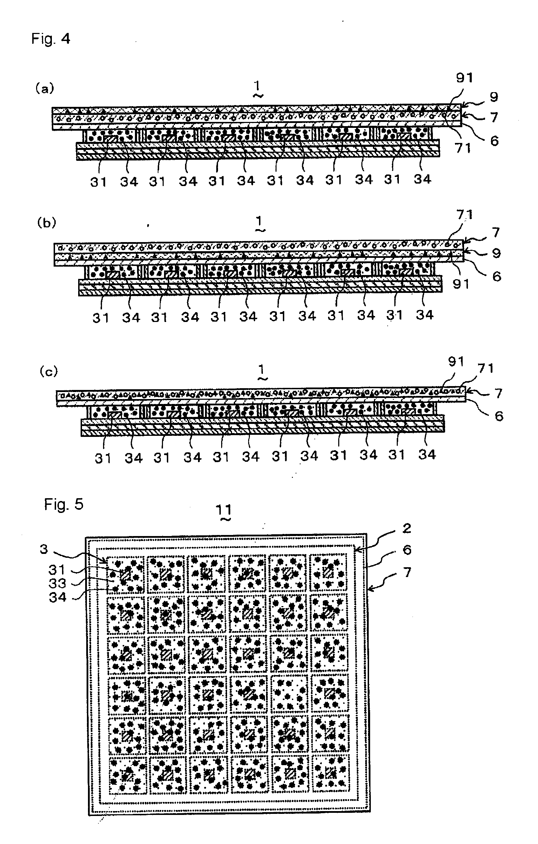

Second modified examples of the light emitting device 1 are shown in Figs. 4(a), (b) and (c). The light emitting device 1 shown in Fig. 4(a) is provided with a fluorescent substance layer 9 which includes fluorescent substances 91 on the surface (on a side of a light derivation surface) of the light diffusion part 7. Meanwhile, the light emitting device 1 shown in Fig. 4(b) is provided with a fluorescent substance layer 9 which includes fluorescent substances 91 on the reverse surface (on a side of a light incident surface) of the light diffusion part 7. Further, the light emitting device 1 shown in Fig. 4(c) is provided with fluorescent substances 91 together with the light diffusion substances 71 included inside the light diffusion part 7. Herein, the fluorescent substances 91 may include yellow fluorescent substances 34 or may include fluorescent substances other than the yellow fluorescent substances 34. Also, two or more kinds of fluorescent substances may be provided as the fluorescent substances 91.

The fluorescent substances 91 adjust light properties of the lights derived from the light diffusion part 7. For example, by using the red or green fluorescent substances as the fluorescent substances 91, there can be obtained white lights supplemented with the red or green lights to be derived from the light diffusion part 7. Thus, the white lights derived from the light diffusion part 7 can have high color rendering properties. Moreover, the fluorescent substances 91 can also correct unevenness of irradiation light intensity etc. due to unevenness of optical properties of the LEDs 31.

The fluorescent substances 91 may include a fluorescent sheet adhered to the surface of the light diffusion part 7 or a fluorescent sheet adhered to the reverse surface of the light diffusion part 7. Thus, the fluorescent substances 91 can be simply and easily arranged on the light diffusion part 7. Moreover, the fluorescent substances 91 may be directly printed on the surface or reverse surface of the light diffusion part 7 by a screen printing and the like.

A third modified example of the light emitting device 1 is shown in Fig. 5. The light emitting device 11 shown in Fig. 5 is a surface type light emitting device that includes a rectangular wiring board 2 and a plurality of light emitting parts 3 arranged in a matrix shape (plane shape) adjacently to one another on the wiring board 2. In the present modified example, these light emitting parts 3 are composed of only the same kind of the light emitting parts 3 each of which includes an LED 31 for emitting a blue light and yellow fluorescent substances 34 so that the light emitting parts 3 are arranged in a matrix shape of 6 columns and 6 rows on the wiring board 2. On the light derivation surface of the light emitting parts 3, there is provided a second transparent optical sealing part 6 for covering the whole light emitting parts 3 in common, and a light diffusion part 7 is provided on the light derivation surface of the second transparent optical sealing part 6.

The light emitting device 11 has the same structure as the light emitting device 1 except that the arrangement of the light emitting parts 3 on the wiring board 2 is different. Herein, the light emitting device 11 may include a plurality of kinds of light emitting parts 3 for emitting lights of colors different from each other. In this case, it is preferable that an activation driver 5 is provided in common to the light emitting parts 3 emitting the lights of the same color so as to be able to perform the on/off control or dimming control for each color of lights. Herein, the number and arrangement of the light emitting parts 3 are not limited to those of the present embodiment. Note that the activation driver, distribution lines and wiring patterns are not shown in Fig. 5 for simplifying the drawing.

According to the present embodiment and the modified examples thereof, it is possible to obtain a linear type light emitting device and a surface type light emitting device having a high efficiency of light derivation and emitting white lights with reduction of luminance unevenness.

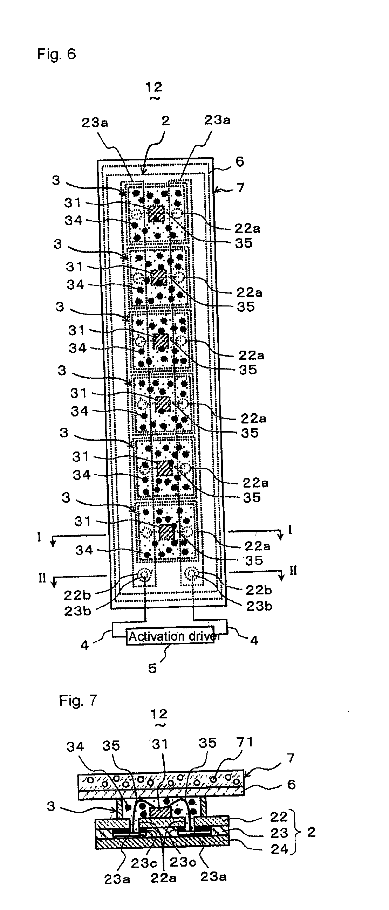

Next, a light emitting device pertaining to a second embodiment of the present invention is described below referring to Figs. 6 to 8. As shown in Fig. 6, the light emitting device 12 is a line-shaped light emitting device that includes a long-sized wiring board 2 and a plurality of light emitting parts 3 which are installed on the wiring board 2 in an array (linear shape) to be adjacent to each other. Each of the light emitting parts 3 includes an LED 31 for emitting a blue light and yellow fluorescent substances 34 which are excited by the blue light from the LED 31 so as to emit yellow lights. The LEDs 31 of the light emitting parts 3 are respectively connected in parallel to a pair of lead frames 23a embedded in the wiring board 2 through wires 35 derived from the upper surfaces thereof. In this configuration, each of the wires 35 derived from the LEDs 31 reaches the lead frame 23a through a wire passing through hole 22a formed in the wiring board 2. The lead frame 23a includes a power line connecting pin 23b standing in fixation at an end portion thereof. The power line connecting pin 23b is protruded on an installation surface of the LEDs 31 of the wiring board 2 through an opening portion 22b formed in the wiring board 2 and is electrically connected to an activation driver 5 through a distribution lines 4. On the light derivation surfaces of the light emitting parts 3, a second transparent optical sealing part 6 is provided for covering the plurality of light emitting parts 3 in common, and a light diffusion part 7 is provided on the light derivation surface of the second transparent optical sealing part 6.

Fig. 7 is a section view across an I-I line in Fig. 6 and shows a joint manner between the LED 31 and the lead frame 23a. As shown in Fig. 7, in the high reflective layer 22 in the vicinity of the LED 31, a pair of wire passing through holes 22a is formed to pass through the high reflective layer 22. The lead frame 23a for carrying electric current to the LED 31 is provided beneath each of the wire passing through holes 22a in a manner of being embedded in the electrically conductive circuit layer 23. The lead frame 23a is adhered to a reverse surface of the high reflective layer 22 opposite to the installation surface of the LED 31 by an insulating member 23c which is an electrically insulating sheet-shaped adhesive in a manner that a wire connecting portion (not shown) of the lead frame 23a is positioned beneath the wire passing through hole 22a. Herein, since the insulating member 23c at a position corresponding to the wire passing through hole 22a is removed, the joint portion of the lead frame 23a is exposed beneath the wire passing through hole 22a. The exposed wire joint portion of the lead frame 23a is wire-bonded to the LED 31 by the wire 35.

Fig. 8 is a section view across an II-II line in Fig. 6 and shows a joint manner between the lead frame 23a and the power line connecting pin 23b. As shown in Fig. 8, in the high reflective layer 22 above a lead frame electrode portion 23d of the lead frame 23a, the opening portion 22b is formed to penetrate the high reflective layer 22. Since the insulating member 23c at a position corresponding to the opening portion 22b is removed, the lead frame electrode portion 23d is exposed beneath the opening portion 22b. The power line connecting pin 23b is jointed to the exposed lead frame electrode portion 23d via solder and the like. A top edge of the power line connecting pin 23b is protruded on the installation surface of the LED 31 on the high reflective layer 22 through the opening portion 22b. An electrically insulating silicon resin 23e is filled in a space between the power line connecting pin 23b and the opening portion 22b.

The light emitting device 12 constructed as described above has the same configuration as that of the light emitting device 1 except that the structure of the wiring board 2 and the electrical joint manner between the wiring board 2 and the LEDs 31 are different. Therefore, the explanation of the same construction as that of the light emitting device 1 is omitted in the following description.

The lead frame 23a is formed by, e.g., by press-cutting a copper hoop member and the surface thereof is subjected to an anti-oxidant treatment such as Ni plating, Ni/Au plating or Ni/Pd/Au plating. Herein, the material of the lead frame 23a is not limited to the copper hoop material and may be an aluminum material and the like.

As the insulating member 23c, e.g., "TSA" manufactured by Toray Industries, Inc., or "Organic Green Sheet" manufactured by Panasonic Electric Works Ltd. is used.

The silicon resin 23e may be substituted by a hollow column resin molded product including an electrically insulating material.

In the present embodiment, the LED 31 may be a face-up type LED which is installed on the high reflective layer 22 via a silicon-based die-bonding material, an epoxy-based die-bonding material, silver paste or the like. The LED 31 is provided with an anode electrode (not shown) and a cathode electrode (not shown) on the surface thereof and the wire 35 is derived from these electrodes.

The wire 35 includes, e.g., a gold wire or aluminum wire. The wire 35 is jointed to the LED 31 or the wire joint portion of the lead frame 23a by thermal bonding or ultrasonic bonding or the like.

The distribution lines 4 includes a connector (not shown) fitting to the power line connecting pin 23b at its distal end which is connected to the power line connecting pin 23b.

An action of the light emitting device 12 as configured above is described below. In the light emitting device 12, by forming the wire passing through hole 22a in the high reflective layer 22, it becomes possible to directly connect the LEDs 31 installed on the high reflective layer 22 and the lead frame 23a embedded in the electrically conductive circuit layer 23 through the wire 35. Whereas, in the light emitting device 1 and the light emitting device 11, by using the wiring pattern 21 having a complicated structure entering the high reflective layer 22 from the electrically conductive circuit layer 23, the conductive connection between the LEDs 31 and the wiring pattern 21 is accomplished. Therefore, by forming the wire passing through hole 22a, it becomes possible to easily perform the conductive connection of the LEDs 31 without requiring the wiring pattern 21 of expense in cost and troublesome when manufacturing. Thus, the cost of manufacturing the light emitting device can be reduced and the manufacture of the light emitting device can be simplified.

By inserting the connector provided at the distal end of the distribution lines 4 into the power line connecting pin 23b, these can be conductively connected. Thus, the connection between the power line connecting pin 23b and the distribution lines 4 can be facilitated so that the assembling properties of the light emitting device 12 can be improved.

According to the present embodiment, it is possible to easily manufacture a line-shaped light emitting device having a high efficiency of light derivation and irradiating the white lights with reduction of the luminance unevenness at a low cost.

In addition, the light emitting device pertaining to the present invention is not limited to the above embodiments and various changes and modifications thereof can be performed. For example, the solid light-emitting element for use in the present light emitting device is not limited to an LED, and an organic EL (electro-luminescent) element etc. may be used. Moreover, the present light emitting device is not limited to a line-shaped light emitting device or plane-shaped light emitting device, and a three-dimensional light emitting device having a plurality of light emitting parts three-dimensionally arranged may be used. Moreover, in the present embodiments, although the light emitting device is adapted to irradiate a white light, it may be adapted to irradiate a light of another color or lights of a plurality of colors by combining the solid light emitting elements and the fluorescent substances in various manners. Further, it is possible that one activation driver may be adapted to control the light emission of a plurality of light emitting devices at the same time.

### [Description of Reference Numerals]

- 1, 11, 12: Light emitting device
- 2: Wiring board
- 22: High reflective layer
- 23: Electrically conductive circuit layer
- 24: Insulating heat dissipation layer
- 3: Light emitting part
- 31: Solid light emitting element (LED)
- 33: First transparent optical sealing part
- 34: (Yellow) fluorescent substance
- 5: Activation driver
- 6: Second transparent optical sealing part
- 7: Light diffusion part
- 71: Light diffusion substance
- 91: Fluorescent substances (for adjusting light properties)

## Claims

1. A light emitting device comprising:
a wiring board;
a plurality of light emitting parts each of which includes a solid light-emitting element installed on the wiring board and a first transparent optical sealing part for sealing the solid light-emitting element, wherein the most part of the sealing parts includes fluorescent substances for wavelength-converting lights emitted from the solid light-emitting element so as to derive the wavelength-converted lights while a part of the sealing parts includes no fluorescent substance and transmits the lights without being wavelength-converted;
an activation driver for controlling the light emission of the plurality of light emitting parts;
a second transparent optical sealing part for covering the plurality of light emitting parts in common; and
a light diffusion part placed on a light derivation surface of the second transparent optical sealing part, wherein
the wiring board has a high reflective layer, an electrically conductive circuit layer and an insulating heat dissipation layer provided in this order from a side of installing the solid light-emitting elements.

2. The light emitting device according to claim 1, wherein the light diffusion part is rendered to have a linear transmittance of 50% or lower.

3. The light emitting device according to claim 1 or 2, wherein the light diffusion part is provided with the fluorescent substances on the surface or reverse surface or inside thereof.

4. The light emitting device according to claim 3, wherein the light diffusion part is provided with a fluorescent sheet adhered to the surface or reverse surface thereof.

5. The light emitting device according to any one of claims 1 to 4, wherein the light diffusion part contains light diffusion substances dispersed inside thereof.

6. The light emitting device according to any one of claims 1 to 5, wherein the plurality of light emitting parts are arranged in an array (line shape) or matrix shape on the wiring board.

7. The light emitting device according to claim 6, wherein the second transparent optical sealing part is formed in a plate shape having a larger size than that necessary for covering the plurality of light emitting parts in common.

8. The light emitting device according to any one of claims 1 to 7, wherein the high reflective layer has a surface thereof including a high light reflective member with a light reflectance of 80% or higher.
